(19) Europäisches Patentamt
European Patent Office
Office européen des brevets

(11) **EP 2 343 332 A1**

(12) **EUROPEAN PATENT APPLICATION**
published in accordance with Art. 153(4) EPC

(43) Date of publication:
**13.07.2011 Bulletin 2011/28**

(51) Int Cl.:
*C08J 5/18* $^{(2006.01)}$    *C08K 3/38* $^{(2006.01)}$
*C08K 5/521* $^{(2006.01)}$    *C08K 7/00* $^{(2006.01)}$
*C08L 33/04* $^{(2006.01)}$    *C08L 101/00* $^{(2006.01)}$
*C09K 5/08* $^{(2006.01)}$    *H01L 23/36* $^{(2006.01)}$

(21) Application number: **09821975.1**

(22) Date of filing: **16.10.2009**

(86) International application number:
**PCT/JP2009/067901**

(87) International publication number:
**WO 2010/047278 (29.04.2010 Gazette 2010/17)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **21.10.2008 JP 2008270849**
**03.03.2009 JP 2009049334**

(71) Applicant: **Hitachi Chemical Company, Ltd.**
**Tokyo 163-0449 (JP)**

(72) Inventors:
• **SUZUKI, Masahiko**
  **Ibaraki 300-4247 (JP)**
• **YOSHIKAWA, Tooru**
  **Ibaraki 300-4247 (JP)**

(74) Representative: **Albrecht, Thomas**
  **Kraus & Weisert**
  **Patent- und Rechtsanwälte**
  **Thomas-Wimmer-Ring 15**
  **80539 München (DE)**

(54) **HEAT CONDUCTING SHEET, MANUFACTURING METHOD THEREOF, AND HEAT RADIATOR THAT UTILIZES SAME**

(57)    A heat conducting sheet including a composition, wherein the composition contains plate-form boron nitride particles (A) having an average particle diameter of more than 10 μm and 60 μm or less, and an organic polymer compound (B) having a glass transition temperature (Tg) of 50°C or lower, the plate-form boron nitride particles (A) are contained in the composition in an amount ranging from 45 to 75% by volume thereof, and are oriented to direct the major axis direction thereof along the thickness direction of the sheet. Thus, there is provided an electrically insulating and heat conducting sheet which can keep a high thermal conductivity while the sheet has additional properties such as flexibility.

## EP 2 343 332 A1

**Description**

Technical Field

The present invention relates to a heat conducting sheet, a manufacturing method thereof, and a heat radiator utilizing the same.

Background Art

In recent years, about multilayered interconnection boards and semiconductor packages, the density of their interconnections or the density of their mounted electronic components has been becoming high. Moreover, the integration degree of their semiconductor elements has been becoming high. Thus, the amount of heat generated per unit area of such heat generating bodies has been turning large. For this reason, techniques have been desired for improving the radiation efficiency of heat from the heat generating bodies.

As a general method for heat radiation, adopted is a method of sandwiching a heat conducting grease or heat conducting sheet between a heat generating body such as a semiconductor package and a heat radiating body made of aluminum or copper, causing these members to adhere onto each other, and conducting heat wherefrom to the outside. From the viewpoint of workability when a heat radiator is fabricated, the heat conducting sheet is better than the heat conducting grease. Thus, investigations have been made about various developments directed to heat conducting sheets.

In order to improve the thermal conductivity thereof, suggested are, for example, various heat conducting composite material compositions wherein heat conducting inorganic particles are incorporated into a matrix material, and formed products therefrom. The material used as the heat conducting inorganic particles is roughly classified into electroconductive materials such as carbon, silver and copper, and electrically insulating materials such as alumina, silica, aluminum nitride and boron nitride. However, when electroconductive materials are each used near interconnections, the material may cause the circuit to be short-circuited. Thus, in many cases, electrically insulating materials are used.

As a sheet made of a heat conducting composite material composition wherein such electrically insulating and heat conducting inorganic particles are incorporated into a matrix material, for example, Patent Document discloses an electrically insulating and heat radiating sheet made of a composition wherein boron nitride powder having a particle thickness of more than 1.4 $\mu$m and having a specific surface area of less than 2.6 m$^2$/g is incorporated into a silicone rubber.

Patent Document 2 discloses a heat conducting sheet made of a polymer composition filled with boron nitride powder wherein the boron nitride powder is magnetically oriented in a determined direction.

Furthermore, Patent Document 3 discloses a heat conducting sheet obtained by laminating primary sheets each made from a kneaded material onto each other, this material being composed of a binder resin including a thermoplastic resin, and inorganic filler particles, and then slicing the resultant laminate in a direction perpendicular to the laminated surfaces.

In recent years, heat conducting sheets are applied to various heat radiators, and it has been becoming necessary to add, to a heat conducting sheet, surface-irregularity-absorbing performance, stress relaxing performance, and other performances. When a heat conducting sheet is applied to heat radiation from a large-area heat generating body such as a display panel, the heat conducting sheet is required to have a function of absorbing distortions and irregularities of respective surfaces of the heat generating body and a heat radiating body, and a function of relaxing thermal stress generated in a difference between the thermal expansion coefficients thereof. Furthermore, the sheet is requited to have such a high thermal conductivity that even when the sheet is formed somewhat thicker, the sheet can conduct heat, and have such a high flexibility that the sheet can adhere closely to the respective surfaces of the heat generating body and the heat radiating body. However, according to conventional heat conducting sheets, it is difficult to make their flexibility and thermal conductivity with each other at a high level. Thus, a further development has been required.

Prior Art Documents

Patent Documents

Patent Document 1: Japanese Patent No. 3209839
Patent Document 2: JP-A-2002-080617
Patent Document 3: JP-A-2002-026202

Disclosure of the Invention

Problems to be solved by the invention

For example, in the heat radiating and heat conducting sheet disclosed in Patent Document 1, the thermal conductance rate is improved by only a means of incorporating heat conducting inorganic particles into a matrix material. Therefore, in order to attain a high thermal conductance rate by the means, it is indispensable to set the blend amount of the heat conducting inorganic particles into a large amount close to the amount corresponding to the closest packing form, thereby forming sufficient heat conducting paths. However, as the blend amount of the inorganic particles is made higher, the flexibility of the heat conducting sheet becomes smaller so as to produce a tendency that the surface-irregularity-absorbing function and the thermal stress relaxing function are damaged.

Against this, in the heat conducting sheet disclosed in Patent Document 2, besides the above-mentioned means, adopted is a means of magnetically orienting boron nitride powder in a determined direction; thus, there is a possibility that a high thermal conductivity can be attained on the basis of a smaller blend amount of the heat conducting inorganic particles. However, there is a room for improving, in the manufacture of sheets, the productivity thereof, costs, energy efficiency, and others.

The heat conducting sheet disclosed in Patent Document 3 is better than the above-mentioned means in the productivity of sheets in the manufacture thereof, and costs, energy efficiency, and others therein. However, a sufficient consideration is not necessarily given about flexibility. In particular, a consideration is insufficient to the matter that when sheets are manufactured, flexible sheet laminates are sliced. As a result, adopted is an inefficient manufacturing process including the impregnation with a plasticizer at a later stage. Thus, a room for improvement remains.

As described above, various investigations directed to heat conducting sheets have been made. However, from the viewpoint of not only high thermal conductivity but also a simple and certain addition of flexibility, stress relaxation and other properties to a sheet, satisfactory results are not given by any method.

In light of such a situation, an object of the invention is to provide an electrically insulating and heat conducting sheet which keeps a high thermal conductivity while the sheet has additional properties such as flexibility. Another object thereof is to provide a method for manufacturing such a heat conducting sheet easily and surely, and a heat radiator using such a heat conducting sheet, thereby having a high heat radiating capability and further incurring only a small risk of causing circuits near the radiator to be short-circuited.

Means for solving the problems

In order to solve the problems, the inventors have repeated eager investigations so as to find out that a specific binder resin is dispersed into a heat conducting sheet in such a manner that plate-form boron nitride particles having a specific size are oriented to direct the major axis direction thereof along the thickness direction of the sheet, whereby the resultant heat conducting sheet can have not only a high thermal conductivity but also flexibility, stress relaxation, and other properties.

Thus, the invention is as follows:

(1) A heat conducting sheet including a composition, the composition containing plate-form boron nitride particles (A) having an average particle diameter of more than 10 $\mu$m and 60 $\mu$m or less, and an organic polymer compound (B) having a glass transition temperature (Tg) of 50°C or lower,
wherein the plate-form boron nitride particles (A) are contained in the composition in an amount ranging from 45 to 75% by volume thereof, and are oriented to direct the major axis direction thereof along the thickness direction of the sheet.

(2) The heat conducting sheet according to item (1), wherein the organic polymer compound (B) is a poly(meth) acrylic acid ester-based polymer compound.

(3) The heat conducting sheet according to item (1) or (2), wherein a flame retardant (C) is further contained in an amount ranging from 5 to 50% by volume of the composition.

(4) The heat conducting sheet according to item (3), wherein the flame retardant (C) is a phosphoric acid ester-based flame retardant.

(5) A method for manufacturing a heat conducting sheet wherein plate-form boron nitride particles are oriented to direct the major axis direction thereof along the thickness direction of the sheet, including:

preparing a composition containing 45 to 75% by volume of the plate-form boron nitride particles (A) having an average particle diameter of more than 10 $\mu$m and 60 $\mu$m or less, and an organic polymer compound (B) having a glass transition temperature (Tg) of 50°C or lower;
using the composition to be formed into a primary sheet or each of primary sheets in which the plate-form boron nitride particles are oriented to be made substantially parallel to main surfaces of the sheet;
laminating the primary sheet onto each other, thereby forming a formed body having a multilayered structure; and

slicing the formed body at an angle of 0 to 30 degrees to any normal line extending from main surfaces of the body.

(6) A method for manufacturing a heat conducting sheet, wherein plate-form boron nitride particles are oriented to direct the major axis direction thereof along the thickness direction of the sheet, including:

preparing a composition containing 45 to 75% by volume of the plate-form boron nitride particles (A) having an average particle diameter of more than 10 $\mu$m and 60 $\mu$m or less, and an organic polymer compound (B) having a glass transition temperature (Tg) of 50°C or lower;
using the composition to be formed into a primary sheet in which the plate-form boron nitride particles are oriented to be made substantially parallel to main surfaces of the sheet;
winding up the primary sheet to have an axis along the orientation direction of the plate-form boron nitride particles, thereby forming a formed body having a multilayered structure; and
slicing the formed body at an angle of 0 to 30 degrees to any normal line extending from main surfaces of the body.

(7) The method according to item (5) or (6), wherein the forming the primary sheet(s) is performed by use of at least one forming methods selected from the group consisting of rolling, pressing, extruding, and painting.

(8) The method according to item (6), wherein the forming the primary sheet is performed at least by use of a forming method of either rolling or pressing.

(9) The method according to any one of items (5) to (8), wherein the slicing is performed in a temperature range from the Tg of the organic polymer compound (B) plus 50°C (temperature 50°C higher than the glass transition temperature) to the Tg minus 20°C (temperature 20°C lower than the glass transition temperature).

(10) A heat radiator having a structure wherein the heat conducting sheet according to any one of items (1) to (4) is interposed between a heat generating body and a heat radiating body.

Effects of the Invention

The heat conducting sheet of the invention has both of a high thermal conductivity and a high flexibility, and further has electrically insulating property. Additionally, flame retardancy, water resistance and other properties can easily be added thereto as necessary. Thus, when the heat conducting sheet is used for, for example, the radiation of heat from the vicinity of an electrical or electronic circuit, an efficient heat radiation can be realized from its heat generating region.

According to the heat conducting sheet manufacturing method of the invention, a heat conducting sheet having both of a high thermal conductivity and a high flexibility can be provided with higher advantages in productivity, costs, energy efficiency, and certainty than according to conventional methods.

Furthermore, according to the heat radiator of the invention, the possibility that a short circuit is caused near a circuit becomes very small. Thus, a complete and efficient heat radiation can be realized.

The disclosure of the present application is related to the subject matters described in Japanese Patent Application No. 2008-270849 filed on October 21, 2008 and Japanese Patent Application No. 2009-049334 on March 3, 2009, and the disclosed contents thereof are incorporated herein by reference.

Best Mode for Carrying Out the Invention

Hereinafter, the invention will be described in detail.

<Heat conducting sheet>

The heat conducting sheet of the invention includes a composition, the composition containing plate-form boron nitride particles (A) having an average particle diameter of more than 10 $\mu$m and 60 $\mu$m or less, and an organic polymer compound (B) having a glass transition temperature (Tg) of 50°C or lower, wherein the plate-form boron nitride particles (A) are contained in the composition in an amount ranging from 45 to 75% by volume thereof, and are oriented to direct the major axis direction thereof along the thickness direction of the sheet.

In the invention, the average particle diameter of the plate-form boron nitride particles (A) is in the range of more than 10 $\mu$m and 60 $\mu$m or less, and is preferably from 15 to 50$\mu$m. When the average particle diameter is more than 10 $\mu$m, the sheet can be prevented from getting brittle. When the diameter is 60 $\mu$m or less, the diameter gives sufficient advantageous effects to the smoothness and the adhesiveness of the sheet.

It is sufficient for the invention that the plate-form boron nitride particles (A) having an average particle diameter in this range are contained. As necessary boron nitride particles having an average particle diameter out of this range may be added thereto.

The average particle diameter of plate-form boron nitride particles is defined as the D50 value obtained when the particles are measured by a laser diffracting/scattering method.

About the particle form also, boron nitride particles that are not in any plate-form may added thereto as necessary.

In the invention, the "plate-form" means the form of a particle which looks like a plate, the particle being in a layer form and having a hexagonal crystal structure. Specifically, the following is defined as the "plate-form" in the invention: any plate-form particle wherein the ratio of a side in the direction parallel to the layer (a-axis direction) to a side in the direction perpendicular to the layer (c-axis direction) (a/c) is 1.5 or more.

The form of the boron nitride particles "other than the plate-form" may be a sphere-aggregated form, wherein plates are aggregated, an indeterminately-shaped aggregate form, the form of granules obtained by pulverizing hexagonal boron nitride, or some other form. Specific examples of the structure of crystals of the boron nitride particles "other than the plate-form" include a hexagonal system (h-BN), a cubic system (c-BN), a wurtzite type (w-BM), a rhombohedral system (r-BN), and a turbostratic structure system (t-BN). Boron nitrides having these crystal structures may be used.

The blend amount of the plate-form boron nitride particles (A) is from 45 to 75% by volume of the composition. When the blend amount is 45% or more by volume, a sufficient thermal conductance rate is obtained. When the blend amount is 75% or less by weight, the composition is excellent in aggregating force so as to be easily made into a sheet.

The blend amount or content by percentage (% by volume) of the plate-form boron nitride particles (A) in the invention is a value obtained in accordance with the following equation:

$$\text{The content (\% by volume) of the plate-form boron nitride particles (A)} =$$

$$(Aw/Ad)/((Aw/Ad) + (Bw/Bd) + (Cw/Cd) + \dots) \times 100$$

wherein

Aw: the mass composition (% by mass) of the plate-form boron nitride particles (A),
Bw: the mass composition (% by mass) of the organic polymer compound (B),
Cw: the mass composition (% by mass) of an optional component other than the above,
Ad: the specific gravity of the plate-form boron nitride particles (A) (any calculation is made in the invention, using 2.3 as Ad),
Bd: the specific gravity of the organic polymer compound (B), and
Cd: the specific gravity of the optional component (C) other than the above.

In the invention, the wording "oriented to direct the major axis direction (a-axis direction) along the thickness direction of the sheet" means the following state: when a SEM (scanning electron microscope) is used to observe a cross section of the sheet about any 50 particles, the average of the angles of the major axis directions (a-axis directions) of the plate-form boron nitride particles to the front surface of the sheet (when any one of the angles is 90 degrees or more, the supplement angle thereof is adopted) falls in the range of 70 to 90 degrees. The plate-form boron nitride particles (A) usable in the composition constituting the heat conducting sheet of the invention have a form advantageous for the orientation (plate-form). The plate-form boron nitride particles are oriented to direct the major axis direction (a-axis direction) of the plate-form boron nitride particles along the thickness of the sheet.

The wording "major axis direction" means a direction parallel to the layer (a-axis direction).

Unless the plate-form boron nitride particles (A) show an orientation as described above in the invention, a sufficient thermal conductivity cannot be obtained. In order to cause the particles to show an orientation as described above, it is advisable to carry out the manufacture thereof by the heat conducting sheet manufacturing method of the invention. Details thereof will be described later.

The plate-form boron nitride particles (A) of the invention are not particularly limited, and specific examples thereof include "PT-100 (trade name)" (manufactured by Momentive Performance Materials Inc., average particle diameter: 45 μm), "HP-1CAW (trade name)" (manufactured by Mizushima Ferroalloy Co., Ltd., average particle diameter: 16 μm), "PT-110 Plus (trade name)" (manufactured by Momentive Performance Materials Inc., average particle diameter: 45 μm), and "HP-1CA (trade name)" (manufactured by Mizushima Ferroalloy Co., Ltd., average particle diameter: 16 μm).

Plate-form boron nitride particles other than the above may be used as far as the particles are plate-form boron nitride particles which are in a "plate-form" and have an average particle diameter of more than 10 μm and 60 μm or less. For example, a substance like an aggregated body (in the form that materials in a plate-form are aggregated) may be subjected to pulverization, crushing, or some other operation, so as to be made into plate-form particles. In a case where the average particle diameter of particles is out of the range of more than 10 μm and 60 μm or less, the average particle diameter can be adjusted into the specified range by removing excessively large and small particles by subjecting the particles to pulverization, sieving or some other operation.

As the organic polymer compound (B), any organic polymer compound having a glass transition temperature (Tg) of 50°C or lower may be used without especial limitation. Specific examples of the organic polymer compound (B) include a poly(meth)acrylic acid ester-based polymer compound made mainly from butyl acrylate, 2-ethylhexyl acrylate and the like (the so-called acrylic rubber), a polymer compound having, as a main structure thereof, a polydimethylsiloxane structure (the so-called silicone resin), a polymer compound having, as a main structure thereof, an polyisoprene structure (the so-called isoprene rubber, or natural rubber), a polymer compound made mainly from chloroprene (polychloroprene, or the so-called neoprene rubber), a polymer compound having, as a main structure thereof, a polybutadiene structure (the so-called butadiene rubber), and any other flexible organic polymer compound generally called "rubber". Of these compounds, particularly preferred is a poly(meth)acrylic acid ester-based polymer compound made mainly from butyl acrylate, 2-ethylhexyl acrylate, or the like for the following reasons: a high flexibility is easily obtained; the chemical stability and the workability are excellent; the adhesiveness is easily controlled; and the polymer compound is relatively inexpensive.

The glass transition temperature (Tg) may be measured by means of a dynamic mechanical analyzer (DMA). The dynamic mechanical analyzer (DMA) may be, for example, an ARES-2KSTD manufactured by TA Instruments Co. As conditions for the measurement, the temperature-raising rate and the measuring frequency are set to 5°C/minnte and 1.0 Hz, respectively.

The poly(meth)acrylic acid ester-based polymer compound is more preferably a copolymer having a Tg of -30°C or lower and having a structure having a polar group (such as a -COOH group, -CN group or -OH group) introduced by copolymerizing acrylic acid, acrylonitrile, hydroxyethyl acrylate, or the like with a copolymer (homopolymer) made from one or more monomers selected from butyl acrylate, ethyl acrylate, 2-ethylhexyl acrylate and the like.

In the invention, the organic polymer compound (B) preferably has a weight-average molecular weight of 10000 to 1000000. The weight-average molecular weight may be measured, using a calibration curve of standard polystyrene through gel permeation chromatography.

A compound usable preferably in the invention is, for example, an acrylic acid ester copolymer manufactured by Nagase ChemteX Corp., "HTR-811DR (trade name)" (butyl acrylate/ethyl acrylate/2-ethylhexyl acrylate copolymer, Mw: 420000, Tg: -43°C solid), an acrylic acid ester copolymer resin manufactured by Nagase ChemteX Corp., "HTR-280DR (trade name)" (butyl acrylate/acrylonitrile/acrylic acid copolymer, Mw: 900000, Tg: -37°C, a 30% by mass solution in toluene and ethyl acetate (1:1)) although the compound is particularly not limited.

The blend amount of the organic polymer compound (B) in the heat conducting sheet of the invention is preferably from 10 to 40% by volume. When the amount is 10% or more by volume, a sufficient sheet strength tends to be obtained. When the amount is 40% or less by volume, a sufficient amount of the boron nitride particles can be contained so that a sufficient thermal conductivity tends to be obtained.

The composition constituting the heat conducting sheet of the invention contains, as components, the plate-form boron nitride particles (A) and the organic polymer compound (B). As necessary, various additives may be added thereto. In a preferred embodiment of the invention, it is preferred to use a flame retardant (C), besides the two components (A) and (B), in order to improve the flame retardancy of the heat conducting sheet. A sheet made from a composition containing a phosphoric acid ester-based flame retardant is advantageous for not only flame retardancy and flexibility but also productivity and costs although the flame retardant (C) is not particularly limited.

The content by percentage of the flame retardant (C) is preferably from 5 to 50% by volume of the composition, more preferably from 10 to 40% by volume thereof When the content by percentage of the flame retardant (C) is 5% or more by volume, the heat conducting sheet can gain a sufficient flame retardancy. When the content by percentage is 50% or less by volume, a fall in the sheet strength can be prevented.

As necessary, various other additives may be added to the composition constituting the heat conducting sheet of the invention, examples of the additives including a toughness improver such as urethane acrylate, an adhesiveness improver such as a silane coupling agent, a titanium coupling agent or an acid anhydride, a wettability improver such as a nonionic surfactant or a fluorochemical surfactant, an antifoaming agent such as silicone oil, and an ion trapping agent such as an inorganic ion exchanger.

The shape of the heat conducting sheet of the invention may be any shape corresponding to one out of various articles to which the heat conducting sheet is applied as far as the above-mentioned desired orientation of the plate-form boron nitride particles can be attained. In the invention, it is preferred that the heat conducting sheet is made from a formed body having a multilayered structure although the structure of the sheet is not particularly limited. When the heat conducting sheet is made from the multilayered structure formed body, an advantage is given to the orientation of the plate-form boron nitride particles, and further the density of the plate-form boron nitride particles is improved so that the thermal conduction efficiency can be improved. A method for manufacturing the heat conducting sheet of the invention will be described later.

Since sheets made of the composition contain the organic polymer having a glass transition temperature (Tg) of 50˚C or lower, many of the sheets have adhesive force. It is therefore preferred in the invention that before the heat conducting sheet is used, (each of) its adhesive surface(s) is protected. The protection of the adhesive surface is attained by the following: when the composition is used to be made into a sheet, a protective film is laid on (each of) its adhesive surface(s).

Examples of the material of the protective film include polyethylene, polyester, polypropylene, polyethylene terephthalate, polyimide, polyetherimide, polyether naphthalate, a methylpentene film and other resins; coated paper; coated cloth; and aluminum and other metals. The protective film may be a multilayered film composed of two or more kinds of films. Use is preferably made of a protective film wherein the front surface of a film is treated with a releasing agent of a silicone type, a silica type or some other type.

<Method for manufacturing the heat conducting sheet>

A method for manufacturing the heat conducting sheet is also included in the scope of the invention.

The method for manufacturing the heat conducting sheet of the invention, wherein plate-form boron nitride particles are oriented to direct the major axis direction thereof along the thickness direction of the sheet, includes the following steps:

the step (a) ofpreparing a composition containing 45 to 75% by volume of plate-form boron nitride particles (A) having an average particle diameter of more than 10 $\mu$m and 60 $\mu$m or less, and an organic polymer compound (B) having a glass transition temperature (Tg) of 50˚C or lower,

the step (b) of using the composition to be formed into a primary sheet or each of primary sheets in which the plate-form boron nitride particles are oriented to be made substantially parallel to main surfaces of the sheet,

the step (c1) of laminating the primary sheets onto each other, thereby forming a formed body having a multilayered structure, and

the step (d) of slicing the formed body at an angle of 0 to 30 degrees to any normal line extending from main surfaces of the body.

The following step (c2) may be substituted for the step (c1):

the step (c2) of winding up the primary sheet to have an axis along the orientation direction of the plate-form boron nitride particles, thereby forming a formed body having a multilayered structure.

Hereinafter, each of the steps will be described.

In the step (a), the preparation of a composition constituting the heat conducting sheet may be performed by use of any method as far as the method is a method making it possible to mix the predetermined plate-form boron nitride particles (A) with the predetermined organic polymer compound (B) into an even state. The composition may be prepared by, for example, a method of dissolving the organic polymer compound (B) beforehand into a solvent to produce a solution, adding to the solution the plate-form boron nitride particles (A), and other additives such as a flame retardant (C) to the solution, mixing these components with each other, stirring the mixture and then drying the mixture, or a method of using roll kneading, a kneader, a Brabender, or an extruder to mix the individual components with each other although the composition-preparing method is not particularly limited.

The solvent wherein the organic polymer compound (B) is to be dissolved is not particularly limited as far as the solvent can be removed by the drying after the mixing and stirring. Examples thereof include acetone, methyl ethyl ketone, methyl butyl ketone, hexane, cyclohexane, ethyl acetate, butyl acetate, benzene, toluene, and xylene.

In the primary-sheet-forming step (b), a technique of common use may be used. Preferably, the step is performed by use of at least one forming method selected from the group consisting of rolling, pressing, extruding, and painting. At least by selecting either rolling or pressing as the forming method, the plate-form boron nitride particles can be oriented in the direction substantially parallel to the main surfaces with a higher certainty. The selection of the method also gives a tendency that at the time of the sheet formation, the plate-form boron nitride particles are easily brought into contact with each other by the application of pressure thereto, so that a high thermal conductivity is easily realized. The thickness (of each) of the formed sheet(s) is preferably smaller from the viewpoint of thermal conductivity. When the thickness of the sheet(s) becomes large, the orientation of the particles becomes insufficient so that the thermal conductivity of the finally yielded heat conducting sheet(s) tends to become poor.

The "state that the plate-form boron nitride particles (A) are oriented to be made substantially parallel to main surfaces of the sheet" means a state that the plate-form boron nitride particles (A) are oriented to lie down along the main surfaces of the sheet. The direction of the plate-form boron nitride particles (A) in the plane of the sheet is controlled by adjusting the direction in which the composition flows when the composition is formed into the sheet. In other words, the direction of the plate-form boron nitride particles (A) is controlled by adjusting the direction in which the composition is passed through a roll for the rolling, the direction in which the composition is pressed, the direction in which the composition is extruded, or the direction in which the composition is painted.

The plate-form boron nitride particles (A) are basically anisotropic particles; therefore, when the composition is formed by rolling, pressing or extruding, or painted, the plate-form boron nitride particles (A) are generally arranged in such a manner that the respective directions thereof are consistent with each other.

The "state that the plate-form boron nitride particles (A) are oriented to be made substantially parallel to the main surfaces of the sheet" is checked by observing a cross section of the sheet about any 50 particles by use of a SEM in the same manner in the method for checking the state that the particles are "oriented to direct the major axis direction (a-axis direction) along the thickness direction of the sheet". Specifically, a SEM is used to observe the cross section of the primary sheet, and it is then checked about any 50 particles whether or not the average of angles of the major axis direction (a-direction) of the plate-form boron nitride particles to the front surface of the primary sheet (when any one of the angles is 90 degrees or more, the supplement angle thereof is adopted) falls in the range of 0 to 20 degrees.

The step (c1) of forming a formed body having a multilayered structure can be performed by laminating the primary sheets yielded in the previous step onto each other.

The form of the laminate is not particularly limited, and is not limited to, for example, a form that independent sheets are in turn put so as to be one onto another. Thus, the form may be a form that a single sheet is folded up without cutting any end thereof.

As a different embodiment of the laminating in the step (c1), the step (c2) is given. Specifically, the primary sheet is wound up to have an axis along the orientation direction of the plate-form boron nitride particles, thereby forming a formed body having a multilayered structure.

The form that the formed body is wound is not limited to a circularly cylindrical form, and may be a rectangularly cylindrical form or some other form. The shape of the formed body may be any shape as far as the shape will not give any inconvenience at the time of slicing the formed body at an angle of 0 to 30 degrees to any normal line extending from the main surfaces in the step (d), which is a subsequent step. For example, it is allowable to make each of the sheets into a circular form, laminate the sheets onto each other to form a circularly columnar body, and perform the slicing in the subsequent step (d) in a way similar to the way of rotary cutting into a thin long sheet.

It is desired that the pressure in the laminating in the step (c1) or (c2), or the tensile force in the winding is adjusted to such a small level that it does not happen that the sliced face of the formed body is damaged so that the orientation of the plate-form boron nitride particles is broken, and to such a large level that the individual sheets in the formed body are appropriately bonded to each other. By adjusting the tensile force when the formed body is produced, sufficient bonding can be generally gained between the individual sheets. However, when the bonding force between the individual sheets is short, it is allowable to paint a solvent, an adhesive or the like into a small thickness onto the front surface of (each of) the sheet(s), and then laminate or wind the sheets or sheet.

The step (d) of slicing the formed body is performed by slicing the formed body into a sheet having a predetermined thickness at an angle of 0 0 to 30 degrees to any normal line extending from main surfaces of the formed body. A cutting tool usable at the time of the slicing is not particularly limited, and is preferably a slicer having a sharp blade, a plane or the like. By use of a cutting tool having a sharp blade, the orientation of particles near the surfaces of the sheet yielded after the slicing is not easily disturbed and further the produced sheet can be easily made into a small thickness.

When the slicing angle is 30 degrees or less, the thermal conductance rate of the resultant heat conducting sheet is good. In a case where the formed body is a laminate, it is sufficient that the laminate is sliced (at an angle within the above-mentioned angle range and) perpendicularly to or substantially perpendicularly to the lamination direction of the primary sheet. In a case where the formed body is a wound body, it is sufficient that the wound body is sliced (at an angle within the angle range and) perpendicularly to or substantially perpendicularly to the axis for the winding. In a case where the formed body is a circularly columnar formed body wherein circular primary sheets are laminated onto each other as descried above, the formed body may be sliced in a way similar to the way of rotary cutting into a thin long sheet.

It is preferred to perform the slicing step (d) in a temperature range from a temperature 50°C higher than the glass transition temperature (Tg) of the composition constituting the heat conducting sheet (Tg + 50°C) to a temperature 20°C lower than the Tg (Tg - 20°C). When the temperature at the time of the slicing is the Tg plus 50°C or lower, the following are prevented: the formed body turns soft not to be easily sliced; and the orientation of the particles in the heat conducting sheet is disturbed. On the other hand, when the temperature at the time of the slicing is the Tg minus 20°C or higher, it does not occur that the formed body turns hard and brittle not to be easily sliced. Additionally, it is easily avoidable that the heat conducting sheet is broken just after the slicing. The temperature at which the slicing is performed is more preferably in a temperature range of Tg + 40°C to Tg - 10°C.

The thickness of the sheet is preferably the average particle diameter or more of the contained boron nitride particles and a size 200 times or less (preferably 100 times or less) the average particle diameter. When the thickness is the average particle diameter or more, it appears that the boron nitride particles can be prevented from falling away from the sheet. When the thickness is the size 200 times or less the average particle diameter, the number of paths through the boron nitride particles becomes small so that the thermal conductivity becomes good.

<Heat radiator>

The invention also includes, in a scope thereof, a heat radiator. The heat radiator of the invention has a structure wherein the heat conducting sheet of the invention is interposed between a heat generating body and a heat radiating body.

The heat generating body usable in the heat radiator of the invention is a body having at least a surface temperature which does not exceed 200˚C. The temperature at which the heat conducting sheet of the invention is preferably usable is from - 10 to 120˚C. The use of the heat conducting sheet in a heat radiator wherein the temperature of the surface(s) of a heat generating body may probably exceed 200˚C tends to be unsuitable, an example of the radiator being a radiator near a nozzle of a jet engine, around the inside of a kiln for ceramics, around the inside of a blast furnace or around the inside of a nuclear reactor, or in a spaceship outer shell or some other. This is because there is a strong possibility that the organic polymer compounds in the sheet are decomposed. Examples of a heat generating body suitable for the heat radiator of the invention include a semiconductor package, a display, an LED, and an electric lamp.

Meantime, the heat radiating body usable in the heat radiator of the invention is not particularly limited, and may be any typical heat radiating body used in a heat radiator. Examples thereof include a heat sink wherein a fin, a plate or the like that is made of aluminum or copper is used, an aluminum or copper block connected to a heat pipe, an aluminum or copper block wherein a cooling liquid is circulated by means of a pump, a Peltier element, and an aluminum or copper block having this element.

Preferred is also any heat radiating body wherein instead of aluminum or copper, a material having a thermal conductance rate of 20 W/mK or more is used, examples of the material including metals such as silver, iron and indium, graphite, diamond, aluminum nitride, boron nitride, silicon nitride, silicon carbide, and aluminum oxide.

The heat radiator of the invention is made up by setting the heat conducting sheet of the invention between the above-mentioned heat generating body and heat radiating body, and bringing their surfaces into contact with each other so as to be fixed. About the fixation of the heat conducting sheet, the method therefor is not particularly limited so as to be any method as far as the method makes it possible to fix the individual contacting surfaces in the state that the contacting surfaces are caused to adhere sufficiently to each other. In order to sustain the sufficient adhesion of each of the contacting surfaces, the method is preferably a method of sustaining pushing-force and is, for example, a method using springs to screw the members, or a method of using clips to pinch the members. According to the heat radiator of the invention, a high heat radiating efficiency can be attained, and further a risk that the radiator causes circuits in the vicinity thereof to be short-circuited is small.

Examples

Hereinafter, the invention will be more specifically described by way of examples. However, the invention is not limited to the examples.

In each of the examples, any thermal conductance rate, which is an index of thermal conductivity, was gained by a method described below.

(Measurement of Thermal Conductance Rate)

A heat conducting sheet to be measured was cut into a size of 1 cm $\times$ 1 cm with a cutter, and the cut piece was arranged to bring one of its surfaces and the other surface into contact with a transistor (2SC2233) and a heat radiating aluminum block, respectively, to form a test sample. Next, an electric current was sent into the test sample while the transistor was pushed. The temperature of the transistor (T1, unit: ˚C) and the temperature of the heat radiating block (T2, unit: ˚C) were measured. From the measured values and the applied electric power (W, unit: W), the thermal resistance (X, unit: ˚C/W) was measured in accordance with the following equation:

$$[\text{Equation 1}]$$

$$X = (T1 - T2)/W$$

From the resultant thermal resistance (X), the film thickness of the cut piece (d, unit: $\mu$m), and a thermal conductivity correction coefficient C obtained from an already-known sample, the thermal conductance rate (Tc, unit: W/mK) was estimated in accordance with the following equation:

[Equation 2]

$$Tc = C * d / X$$

(Example 1)

The following were heated to 220°C and kneaded: 15.00 g of plate-form boron nitride particles (A)(trade name: "PT-110" , manufactured by Momentive Performance Materials Inc.; average particle diameter: 45 μm); 1.96 g of an acrylic acid ester copolymer resin (B) (a butyl acrylate/ethyl acrylate/2-hydroxyethyl methacrylate copolymer; trade name: HTR-811DR, manufactured by Nagase ChemteX Corp.; Mw: 420000; Tg: -29.4°C); and 1.40 g of a phosphoric acid ester-based flame retardant (C) (trade name: CR-741, manufactured by Daihachi Chemical Industry Co., Ltd.). In this way, a composition was prepared.

The blend percentages in the composition calculated from the specific gravities of the raw materials were as follows: 70% by volume of the plate-form boron nitride particles (A); 17.5% by volume of the acrylic acid ester copolymer resin (B); and 12.5% by volume of the phosphoric acid ester-based flame retardant (C).

One gram of the previously prepared composition was sandwiched between PET films subjected to releasing treatment, and then a press having a tool surface, 5 cm × 10 cm in size, was used to press the workpiece at a tool pressure of 10 MPa and a tool temperature of 120°C over 10 seconds to yield a primary sheet of 0.3 mm in thickness. This operation was repeated to produce many primary sheets.

About each of the primary sheets, the "state that the plate-form boron nitride particles (A) were oriented to be made substantially parallel to the main surfaces of the sheet" was confirmed as follows:

A SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 5 degrees. It was recognized that the major axis directions of the plate-form boron nitride particles were oriented to be made substantially parallel to the main surfaces of the primary sheet.

The resultant primary sheets were each cut into a size of 2 cm × 2 cm, and thirty seven sheets thereof were laminated onto each other. The laminate was lightly pushed by hand, so as to bond any adjacent two of the individual primary sheets onto each other, thereby yielding a formed body of 1.1 cm in thickness. This formed body was cooled with dry ice, and then a laminate-cross-section thereof, 1.1 cm × 2 cm in size, was shaved with a plane at -10°C, (or was sliced at an angle of 5 degrees to any normal line extending from the surfaces of the primary sheet), to yield a heat conducting sheet of Example 1 having a size of 1.1 cm × 2 cm × 0.51 mm.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 85 degrees. It was recognized that the major axis directions of the plate-form boron nitride particles were oriented along the thickness direction of the heat conducting sheet.

The adhesiveness of the resultant heat conducting sheet was good. The thermal conductance rate thereof was estimated. As a result, the sheet showed a good value of 25.9 W/mK.

(Example 2)

A heat conducting sheet of Example 2 was yielded under the same conditions as in Example 1 except that the raw materials were used in the following amounts: the plate-form boron nitride particles (A): 13.08 g (60% by volume); the acrylic acid ester copolymer resin (B): 2.56 g (22.5% by volume); and the phosphoric acid ester-based flame retardant (C): 1.99 g (17.5% by volume).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 3 degrees. It was recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 88 degrees. It was recognized that the major axis directions of the plate-form boron nitride particles were oriented along the thickness direction of the heat conducting sheet.

The adhesiveness of the resultant heat conducting sheet was good. The thermal conductivity thereof was estimated. As a result, the sheet showed a good value of 26.9 W/mK.

(Example 3)

A heat conducting sheet of Example 3 was yielded under the same conditions as in Example 1 except that the raw materials were used in the following amounts: the plate-form boron nitride particles (A): 11.25 g (50% by volume); the acrylic acid ester copolymer resin (B): 3.24 g (27.5% by volume); and the phosphoric acid ester-based flame retardant (C): 2.64 g (22.5% by volume).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 10 degrees. It was recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 82 degrees. It was recognized that the major axis directions of the plate-form boron nitride particles were oriented along the thickness direction of the heat conducting sheet.

The adhesiveness of the resultant heat conducting sheet was good. The thermal conductivity thereof was estimated. As a result, the sheet showed a good value of 15.8 W/mK.

(Example 4)

A heat conducting sheet of Example 4 was yielded under the same conditions as in Example 1 except that the raw materials were used in the following amounts: the plate-form boron nitride particles (A): 10.86 g (45% by volume); the acrylic acid ester copolymer resin (B):3.78 g (30.0% by volume); and the phosphoric acid ester-based flame retardant (C): 3.15 g (25.0% by volume).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 16 degrees. It was recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 72 degrees. It was recognized that the major axis directions of the plate-form boron nitride particles were oriented along the thickness direction of the heat conducting sheet.

The adhesiveness of the resultant heat conducting sheet was good. The thermal conductivity thereof was estimated. As a result, the sheet showed a passable value of 10.7 W/mK.

(Example 5)

A heat conducting sheet of Example 5 was yielded under the same conditions as in Example 3 except that as the plate-form boron, nitride particles (A) of a raw material, use was made of plate-form boron nitride particles "HP-1CAW (trade name)" (manufactured by Mizushima Ferroalloy Co., Ltd.; average particle diameter: 16 $\mu$m).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 14 degrees. It was recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles therein, measurements were made, along the direction in which the particles were viewed, about the respective angles of the major axis directions of the plate-form boron nitride particles to the front surface of the heat conducting sheet. the average thereof was then calculated. As a result, the average was 78 degrees. It was recognized that the major axis directions of the plate-form boron nitride particles were oriented along the thickness direction of the heat conducting sheet.

The adhesiveness of the resultant heat conducting sheet was good. The thermal conductivity thereof was estimated. As a result, the sheet showed a good value of 14.4 W/mK.

(Example 6)

A heat conducting sheet of Example 6 was yielded under the same conditions as in Example 2 except that as the plate-form boron nitride particles (A) of a raw material, use was made of plate-form boron nitride particles "HP-1 CAW (trade name)" (manufactured by Mizushima Ferroalloy Co., Ltd.; average particle diameter: 16 $\mu$m).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 14 degrees. It was recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 78 degrees. It was recognized that the major axis directions of the plate-form boron nitride particles were oriented along the thickness direction of the heat conducting sheet.

The adhesiveness of the resultant heat conducting sheet was substantially good. The thermal conductivity thereof was estimated. As a result, the sheet showed a good value of 11.9 W/mK.

(Comparative Example 1)

A heat conducting sheet of Comparative Example 1 was yielded under the same conditions as in Example 1 except that the raw materials were used in the following amounts: the plate-form boron nitride particles (A): 10.49 g (40% by volume); the acrylic acid ester copolymer resin (B): 4.44 g (32.5% by volume); and the phosphoric acid ester-based flame retardant (C): 3.76 g (27.5% by volume).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 30 degrees. It was not recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 66 degrees. The major axis directions of the plate-form boron nitride particles were somewhat oriented along the thickness direction of the heat conducting sheet.

The adhesiveness of the resultant heat conducting sheet was good. However, when the thermal conductance rate thereof was estimated, the sheet showed a value of 8.1 W/mK, which was not a good value.

(Comparative Example 2)

A heat conducting sheet of Comparative Example 2 was yielded under the same conditions as in Example 1 except that the raw materials were used in the following amounts: the plate-form boron nitride particles (A): 7.83 g (30% by volume); the acrylic acid ester copolymer resin (B): 5.10 g (37.5% by volume); and the phosphoric acid ester-based flame retardant (C): 4.42 g (32.5% by volume).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 41 degrees. It was not recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 52 degrees. The major axis directions of the plate-form boron nitride particles were somewhat oriented along the thickness direction of the heat conducting sheet.

The adhesiveness of the resultant heat conducting sheet was good. However, when the thermal conductance rate thereof was estimated, the sheet showed a value of 7.2 W/mK, which was not a good value.

(Comparative Example 3)

As raw materials, the following were used: the plate-form boron nitride particles (A): 15.35 g (80% by volume); the acrylic acid ester copolymer resin (B): 1.25 g (12.5% by volume); and the phosphoric acid ester-based flame retardant (C): 0.75 g (7.5% by volume). In order to prepare a composition similar to that of Example 1, the raw materials were heated to 120°C and kneaded. However, the composition was poor in aggregating performance not to turn into a sheet form. Thus, a heat conducting sheet of Comparative Example 3 was not yielded.

(Comparative Example 4)

A heat conducting sheet of Comparative Example 4 was yielded under the same conditions as in Comparative Example 2 except that as the plate-form boron nitride particles (A) of a raw material, use was made of plate-form boron nitride particles "HP-1CAW (trade name)" (manufactured by Mizushima Ferroalloy Co., Ltd.; average particle diameter: 16 μm).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 39 degrees. It was not recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 55 degrees. The major axis directions of the plate-form boron nitride particles were somewhat oriented along the thickness direction of the heat conducting sheet.

The adhesiveness of the resultant heat conducting sheet was good. However, when the thermal conductivity thereof was estimated, the sheet showed a value of 8.7 W/mK, which was not a good value.

(Comparative Example 5)

Instead of the plate-form boron nitride particles (A) as one of the raw materials, use was made of plate-form boron nitride particles "HP-1 (trade name)" (manufactured by Mizushima Ferroalloy Co., Ltd.; average particle diameter: 10 μm). In order to prepare a composition similar to that of Example 3, the raw materials were heated to 120°C and kneaded. However, the composition was poor in aggregating performance not to turn into a sheet form. Thus, a heat conducting sheet of Comparative Example 5 was not yielded.

(Comparative Example 6)

Instead of the plate-form boron nitride particles (A) as one of the raw materials, use was made of spherical boron nitride particles "FS-3 (trade name)" (manufactured by Mizushima Ferroalloy Co., Ltd.; average particle diameter: 50 μm). In order to prepare a composition similar to that of Example 2, the raw materials were heated to 120°C and kneaded. However, the composition was poor in aggregating performance not to turn into a sheet form. Thus, a heat conducting sheet of Comparative Example 6 was not yielded.

Points of individual Examples and Comparative Examples described above are shown in Tables 1 and 2.

(Comparative Example 7)

Instead of the plate-form boron nitride particles (A) as one of the raw materials, use was made of plate-form boron nitride particles "HP-40 (trade name)" (manufactured by Mizushima Ferroalloy Co., Ltd.; average particle diameter: 6.9 $\mu$m) . In order to prepare a composition similar to that of Example 3, the raw materials were heated to 120˚C and kneaded. However, the composition was poor in aggregating performance not to turn into a sheet form. Thus, a heat conducting sheet of Comparative Example 7 was not yielded.

(Comparative Example 8)

A heat conducting sheet of Comparative Example 4 was yielded under the same conditions as in Comparative Example 1 except that instead of the plate-form boron nitride particles (A) as one of the raw materials, use was made of plate-form boron nitride particles "HP-40 (trade name)" (manufactured by Mizushima Ferroalloy Co., Ltd.; average particle diameter: 6.9 $\mu$m).

The SEM (scanning electron microscope) was used to observe a cross section of each of the resultant primary sheets, and about any 50 plate-form boron nitride particles, measurements were made, along the direction in which the particles were viewed, about the respective angles of the major axis directions of the plate-form boron nitride particles to the front surface of the primary sheet. The average thereof was then calculated. As a result, the average was 37 degrees. It was not recognized that the major axis directions of the plate-form boron nitride particles were oriented to be made substantially parallel to the main surfaces of the primary sheet.

The SEM (scanning electron microscope) was used to observe a cross section of the resultant heat conducting sheet, and about any 50 plate-form boron nitride particles, measurements were made, along the direction in which the particles were viewed, about the respective angles of the major axis directions of the plate-form boron nitride particles to the front surface of the heat conducting sheet. The average thereof was then calculated. As a result, the average was 57 degrees. The major axis directions of the plate-form boron nitride particles were somewhat oriented along the thickness direction of the heat conducting sheet.

The adhesiveness of the resultant heat conducting sheet was good. However, when the thermal conductance rate thereof was estimated, the sheet showed a value of 7.0 W/mK, which was not a good value.

(Comparative Example 9)

As plate-form boron nitride particles (A) of a raw material, use was made of plate-form boron nitride particles "HP-1CAW (trade name)" (manufactured by Mizushima Ferroalloy Co., Ltd.; average particle diameter: 16 $\mu$m). The plate-form boron nitride particles (A), the acrylic acid ester copolymer resin (B) and the phosphoric acid ester-based flame retardant (C) were used in the following amounts, respectively: 15.35 g (80% by volume); 1.25 g (12.5% by volume); and 0.75 g (7.5% by volume). In order to prepare a composition similar to that of Example 1, the raw materials were heated to 120˚C and kneaded. However, the composition was poor in aggregating performance not to turn into a sheet form. Thus, a heat conducting sheet of Comparative Example 9 was not yielded.

[Table 1]

| | Example 1 | Example 2 | Example 3 | Example 4 | Example 5 | Example 6 |
|---|---|---|---|---|---|---|
| Boron nitride particles (A) | PT-110 Plate-form | PT-110 Plate-form | PT-110 Plate-form | PT-110 Plate-form | HP-1CAW Plate-form | HP-1CAW Plate-form |
| volume of blended particles (A) (%) | 70 | 60 | 50 | 45 | 50 | 60 |
| Average particle diameter of particles (A) ($\mu$m) | 45 | 45 | 45 | 45 | 16 | 16 |

(continued)

|  | Example 1 | Example 2 | Example 3 | Example 4 | Example 5 | Example 6 |
|---|---|---|---|---|---|---|
| Formation of heat conducting sheet | ○ | ○ | ○ | ○ | ○ | ○ |
| Thermal conductance rate of resultant sheet (w/mk) | 25.9 | 26.9 | 15.8 | 10.7 | 14.4 | 11.9 |
| Orientation angle of boron nitride (A) to sheet thickness (˚) | 85 | 88 | 82 | 72 | 78 | 78 |

[Table 2]

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| Boron nitride particles (A) | PT-110 Plate-form | PT-110 Plate-form | PT-110 Plate-form | BP- 1CAW Plate-form | HP-1 I Plate-form | FS-3 spherical | HP-40 Plate-form | HP-40 Plate-form | HP-1CAW Plate-form |
| volume of blended particles (A) (%) | 40 | 30 | 80 | 30 | 50 | 60 | 50 | 40 | 80 |
| Average particle diameter of particles (A) ($\mu$m) | 45 | 45 | 45 | 16 | 10 | 50 | 6.9 | 6.9 | 16 |
| Formation of heat conducting sheet | ○ | ○ | × | ○ | × | × | × | ○ | × |
| Thermal conductance rate of resultant sheet (w/mk) | 8.1 | 7.2 | - | 8.7 | - | - | - | 7.0 | - |
| Orientation angle of boron nitride (A) to sheet thickness (°) | 66 | 52 | - | 55 | - | - | - | 57 | - |

EP 2 343 332 A1

Industrially Applicability

The heat conducting sheet of the invention has both of a high thermal conductivity and a high flexibility, and further has electrically insulating property. As necessary, flame retardancy, water resistance and other performances can easily be added thereto. Thus, when the sheet is used to radiate heat near, for example, an electrically/electronic circuit, an efficient radiation of heat from its heat generating region can be realized. Moreover, according to the heat conducting sheet manufacturing method, it is possible to provide a heat conducting sheet having a high thermal conductivity and a flexibility more advantageously in productivity, costs, energy efficiency, and certainty than according to conventional method.

Furthermore, according to the heat radiator of the invention, the possibility that a short circuit is caused near a circuit becomes very small. Thus, a complete and efficient heat radiation can be realized.

**Claims**

1. A heat conducting sheet comprising a composition, the composition containing plate-form boron nitride particles (A) having an average particle diameter of more than 10 $\mu$m and 60 $\mu$m or less, and an organic polymer compound (B) having a glass transition temperature (Tg) of 50˚C or lower,
   wherein the plate-form boron nitride particles (A) are contained in the composition in an amount ranging from 45 to 75% by volume thereof, and are oriented to direct the major axis direction thereof along the thickness direction of the sheet.

2. The heat conducting sheet according to claim 1, wherein the organic polymer compound (B) is a poly(meth)acrylic acid ester-based polymer compound.

3. The heat conducting sheet according to claim 1 or 2, wherein a flame retardant (C) is further contained in an amount ranging from 5 to 50% by volume of the composition.

4. The heat conducting sheet according to claim 3, wherein the flame retardant (C) is a phosphoric acid ester-based flame retardant.

5. A method for manufacturing a heat conducting sheet wherein plate-form boron nitride particles are oriented to direct the major axis direction thereof along the thickness direction of the sheet, comprising:

   preparing a composition containing 45 to 75% by volume of the plate-form boron nitride particles (A) having an average particle diameter of more than 10 $\mu$m and 60 $\mu$m or less, and an organic polymer compound (B) having a glass transition temperature (Tg) of 50˚C or lower;
   using the composition to be formed into a primary sheet or each of primary sheets in which the plate-form boron nitride particles are oriented to be made substantially parallel to main surfaces of the sheet;
   laminating the primary sheet onto each other, thereby forming a formed body having a multilayered structure; and
   slicing the formed body at an angle of 0 to 30 degrees to any normal line extending from main surfaces of the body.

6. A method for manufacturing a heat conducting sheet, wherein plate-form boron nitride particles are oriented to direct the major axis direction thereof along the thickness direction of the sheet, comprising:

   preparing a composition containing 45 to 75% by volume of the plate-form boron nitride particles (A) having an average particle diameter of more than 10 $\mu$m and 60 $\mu$m or less, and an organic polymer compound (B) having a glass transition temperature (Tg) of 50˚C or lower;
   using the composition to be formed into a primary sheet in which the plate-form boron nitride particles are oriented to be made substantially parallel to main surfaces of the sheet;
   winding up the primary sheet to have an axis along the orientation direction of the plate-form boron nitride particles, thereby forming a formed body having a multilayered structure; and
   slicing the formed body at an angle of 0 to 30 degrees to any normal line extending from main surfaces of the body.

7. The method according to claim 5 or 6, wherein the forming the primary sheet(s) is performed by use of at least one forming methods selected from the group consisting of rolling, pressing, extruding, and painting.

8. The method according to claim 6, wherein the forming the primary sheet is performed at least by use of a forming method of either rolling or pressing.

9. The method according to any one of claims 5 to 8, wherein the slicing is performed in a temperature range from the Tg of the organic polymer compound (B) plus 50˚C (temperature 50˚C higher than the glass transition temperature) to the Tg minus 20˚C (temperature 20˚C lower than the glass transition temperature).

10. A heat radiator having a structure wherein the heat conducting sheet according to any one of claims 1 to 4 is interposed between a heat generating body and a heat radiating body.

# EP 2 343 332 A1

<table>
<tr><td colspan="2" align="center"><strong>INTERNATIONAL SEARCH REPORT</strong></td><td>International application No.<br><br>PCT/JP2009/067901</td></tr>
</table>

**A. CLASSIFICATION OF SUBJECT MATTER**

*C08J5/18*(2006.01)i, *C08K3/38*(2006.01)i, *C08K5/521*(2006.01)i, *C08K7/00* (2006.01)i, *C08L33/04*(2006.01)i, *C08L101/00*(2006.01)i, *C09K5/08*(2006.01)i, *H01L23/36*(2006.01)i

According to International Patent Classification (IPC) or to both national classification and IPC

**B. FIELDS SEARCHED**

Minimum documentation searched (classification system followed by classification symbols)
C08J5/18, C08K3/38, C08K3/00-13/08, C08L1/00-101/16

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2002-26202 A  (3M Innovative Properties Co.), 25 January 2002 (25.01.2002), claims; paragraphs [0012], [0017] to [0019], [0024] to [0036]; examples; drawings & TW 567219 B          & KR 20020002257 A | 1-10 |
| X | JP 2002-164481 A  (3M Innovative Properties Co.), 07 June 2002 (07.06.2002), claims; paragraphs [0012], [0014], [0018]; examples; drawings (Family: none) | 1-10 |

[X] Further documents are listed in the continuation of Box C.      [ ] See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search<br>    09 December, 2009 (09.12.09) | Date of mailing of the international search report<br>    22 December, 2009 (22.12.09) |
|---|---|
| Name and mailing address of the ISA/<br>    Japanese Patent Office | Authorized officer |
| Facsimile No. | Telephone No. |

Form PCT/ISA/210 (second sheet) (April 2007)

19

EP 2 343 332 A1

**INTERNATIONAL SEARCH REPORT**

| International application No. |
| --- |
| PCT/JP2009/067901 |

C (Continuation).  DOCUMENTS CONSIDERED TO BE RELEVANT

| Category* | Citation of document, with indication, where appropriate, of the relevant passages | Relevant to claim No. |
| --- | --- | --- |
| P,X | JP 2008-280496 A  (Hitachi Chemical Co., Ltd.), 20 November 2008 (20.11.2008), claims; paragraphs [0021] to [0028], [0032] to [0039]; examples (Family: none) | 1-10 |

Form PCT/ISA/210 (continuation of second sheet) (April 2007)

20

## REFERENCES CITED IN THE DESCRIPTION

**Patent documents cited in the description**

- JP 3209839 B
- JP 2002080617 A
- JP 2002026202 A
- JP 2008270849 A
- JP 2009049334 A